# EUROPEAN PATENT SPECIFICATION

(11) **EP 3 656 889 B1**
(45) Date of publication and mention of the grant of the patent: **01.06.2022**
(21) Application number: 18917040.0
(22) Date of filing: 08.10.2018
(51) Int. Cl.: C23C 16/40, C23C 16/44, C23C 16/18, C23C 16/455, H01L 21/02, C01G 23/00, H01L 49/02, C23C 16/56

(54) **METHOD FOR PREPARING COPPER CALCIUM TITANATE THIN FILM**
VERFAHREN ZUR HERSTELLUNG EINER KALZIUMKUPFER-TITANATFOLIE
PROCÉDÉ DESTINÉ À PRÉPARER UNE PELLICULE MINCE DE TITANATE DE CUIVRE ET DE CALCIUM

(43) Date of publication of application: 27.05.2020
(73) Proprietor: SHENZHEN GOODIX TECHNOLOGY CO., LTD., Shenzhen, Guangdong 518045 (CN)
(72) Inventor: LU, Bin, Shenzhen, Guangdong 518045 (CN); SHEN, Jian, Shenzhen, Guangdong 518045 (CN)
(74) Representative: Herrero & Asociados, S.L.
(86) International application number: PCT/CN2018/109323
(87) International publication number: WO 2020/073162

(56) References cited:
- CN-A- 101 555 591
- CN-A- 101 595 244
- CN-A- 101 595 244
- CN-A- 107 540 402
- US-A1- 2008 218 940
- RAFFAELLA LO NIGRO: "MOCVD Approach to the Growth of Calcium Copper Titanate (CaCu 3 Ti 4 O 12 ) Thin Films: The Role of the Substrate Nature on Film Structural and Dielectrical Properties", ADVANCED MATERIALS INTERFACES, vol. 4, no. 8, 15 March 2017 (2017-03-15), page 1600975, XP055723797, DE ISSN: 2196-7350, DOI: 10.1002/admi.201600975
- LI SHENGTAO ET AL: "Dielectric properties of B-doped CaCu3Ti4O12 ceramics", PROCEEDINGS OF 2011 INTERNATIONAL CONFERENCE ON ELECTRICAL INSULATING MATERIALS, THE INSTITUTE OF ELECTRICAL ENGINEERS, JAPAN, 6 September 2011 (2011-09-06), pages 482-485, XP032600389, ISBN: 978-4-88686-074-3 [retrieved on 2014-06-04]
- GUPTA N ET AL: "Photo-assisted metal-organic chemical vapor deposition of CaCu3Ti4O12(CCTO) thin films", MATERIALS SCIENCE IN SEMICONDUCTOR PROCESSING, ELSEVIER SCIENCE PUBLISHERS B.V., BARKING, UK, vol. 16, no. 5, 24 April 2013 (2013-04-24) , pages 1297-1302, XP028574345, ISSN: 1369-8001, DOI: 10.1016/J.MSSP.2013.03.013
- MARIA R CATALANO ET AL: "CaCuTiOthin films on conductive oxide electrode: A comparative study between chemical and physical vapor deposition routes", MATERIALS CHEMISTRY AND PHYSICS, ELSEVIER SA, SWITZERLAND, TAIWAN, REPUBLIC OF CHINA, vol. 133, no. 2, 11 February 2012 (2012-02-11), pages 1108-1115, XP028478969, ISSN: 0254-0584, DOI: 10.1016/J.MATCHEMPHYS.2012.02.024 [retrieved on 2012-02-18]
- MOHSEN AHMADIPOUR ET AL: "A Short Review on Copper Calcium Titanate (CCTO) Electroceramic: Synthesis, Dielectric Properties, Film Deposition, and Sensing Application", NANO-MICRO LETTERS, vol. 8, no. 4, 1 October 2016 (2016-10-01) , pages 291-311, XP055723818, ISSN: 2311-6706, DOI: 10.1007/s40820-016-0089-1

## Description

### TECHNICAL FIELD

The present application relates to the technical field of preparing inorganic nonmetallic materials, and in particular, relates to a calcium copper titanate film preparation method and a calcium copper titanate film.

### BACKGROUND

Calcium copper titanate (CaCu₃Ti₄O₁₂, CCTO) is a new type of ceramic material discovered in recent years, with an ultra-high dielectric constant (about 10⁴-10⁵) and a wide frequency and temperature stability range. Preparation of a high-quality CCTO film is of great significance to miniaturization of an electronic device (for example, a capacitor).

At present, a process for preparing a CCTO film mainly include metal-organic chemical vapor deposition (MOCVD), pulsed laser deposition (PLD), radio frequency sputtering (RF Sputtering), a sol-gel method, or the like. Compared with other processes, MOCVD may achieve deposition of the CCTO film on a surface of a 3-dimensional (3 Dimensions, 3D) structure such as a via, a trench, a pillar, or the like, and a basic principle is to simultaneously introduce a gaseous precursor containing calcium (Ca), copper (Cu) and titanium (Ti), and oxygen into a reaction chamber, and react at a high temperature so as to generate the CCTO film.

However, depositing the CCTO thin film on the surface of 3D structure such as the via, the trench, the pillar or the like by the MOCVD process has certain limitations on an aspect ratio of the 3D structure. Generally, a smaller aspect ratio is required, for example, the aspect ratio is less than 10, and otherwise it is difficult to control film thickness uniformity of the film.
"RAFFAELLA LO NIGRO: "MOCVD Approach to the Growth of Calcium Copper Titanate (CaCu3Ti4O12) Thin Films: The Role of the Substrate Nature on Film Structural and Dielectrical Properties", ADVANCED MATERIALS INTERFACES, vol. 4. No. 8, 15 March 2017 (2017-03-15), page 1600975", discloses the role of the substrate nature on film structural and dielectrical properties about the MOCVD approach to the growth of CCTO film. The MOCVD process is based on a molten mixture of the Ca(hfa)₂•tetraglyme, Ti(tmhd)₂(O-*i*Pr)₂, and Cu(tmhd)₂ precursors as multi-component source. The deposited CCTO films are epitaxial on single crystal substrates, while polycrystalline films have been found on metal electrodes.
"LI SHENGTAO ET AL: "Dielectric properties of B-doped CaCu3Ti4O12 ceramics". PROCEEDINGS OF 2011 INTERNATIONAL CONFERENCE ON ELECTRICAL INSULATING MATERIALS, THE INSTITUTE OF ELECTRICAL ENGINEERS, JAPAN, 6 September 2011 (2011-09-06), Pages 482-485", discloses that the amount of B₂O₃ can increase the dielectric constant of CCTO keeping 10⁴ in the frequency range from 10⁻¹ Hz to 10⁶ Hz and can also decrease the dielectric loss of CCTO since it can increase the resistance of the grain boundary.
"GUPTA N ET AL: "Photo-assisted metal-organic chemical vapor deposition of CaCu3Ti4O12 (CCTO) thin films", MATERIALS SCIENCE IN SEMICONDUCTOR PROCESSING, ELSEVIER SCIENCE PUBLISHERS B.V, BARKING, UK, vol. 16, no. 5, 24 April 2013 (2013-04-24), pages 1297-1302", discloses that incoherent light source based photo-assisted metal-organic chemical vapor deposition (MOCVD) has been used to prepare CCTO thin films on Si/SiO₂ substrates. Key to this unique processing technique is the use of UV radiation as an additional source of energy in conjunction to the thermal energy.

### SUMMARY

The present application provides a calcium copper titanate film preparation method and a calcium copper titanate film, where the calcium copper titanate film has excellent step coverage, film thickness uniformity and film continuity, and is particularly suitable for a high aspect ratio structure, and further an oxide layer of a doped element may be deposited in the process of preparing the calcium copper titanate film, thereby reducing dielectric loss of the calcium copper titanate film and improving performance.

According to a first aspect, the present application provides a calcium copper titanate film preparation method as described in claim 1.

Therefore, in a calcium copper titanate film preparation method provided by an embodiment of the present application, at least one titanium dioxide layer, at least one copper oxide layer and at least one calcium oxide or calcium carbonate layer are deposited on the substrate, and then high-temperature annealing treatment is performed in an oxygen-containing atmosphere to obtain a calcium copper titanate film, so that a thickness of the calcium copper titanate film may be accurately controlled, and a reaction rate may be controlled.

In some possible implementations, a molar ratio of a Ca element, a Cu element and a Ti element in the layered deposition structure is equal to or close to 1:3:4.

In some possible implementations, the forming the layered deposition structure on the substrate includes:
depositing the titanium dioxide layer, the copper oxide layer, and the calcium oxide or calcium carbonate layer on the substrate by using an atomic layer deposition process or a chemical vapor deposition process.

It should be noted that by using the atomic layer deposition process, substances may be plated on a surface of the substrate layer by layer in a monoatomic (including a signal atom) manner by alternately introducing two different precursors into the reaction chamber for surface adsorption reaction.

Therefore, by using the atomic layer deposition process, the titanium dioxide layer, the copper oxide layer, and the calcium oxide or calcium carbonate layer are deposited on the substrate, and then the high-temperature annealing treatment is performed in the oxygen-containing atmosphere to obtain the calcium copper titanate film. Such calcium copper titanate film has high quality, excellent step coverage, and good film thickness uniformity, and a thickness of the calcium copper titanate film may be accurately controlled; also, there is no relevant limitation on the aspect ratio of the 3D structure when the calcium copper titanate film is deposited on the surface of the 3D structure.

It should be noted that by using the chemical vapor deposition process, a large deposition rate may be achieved by simultaneously introducing two different precursors into the reaction chamber to deposit the material; also, there is no relevant limitation on the aspect ratio of the 3D structure when the calcium copper titanate film is deposited on the surface of the 3D structure.

Therefore, by using the chemical vapor deposition process, the titanium dioxide layer, the copper oxide layer, and the calcium oxide or calcium carbonate layer are deposited on the substrate, and then the high-temperature annealing treatment is performed in the oxygen-containing atmosphere to obtain the calcium copper titanate film, so that a deposition rate may be improved; and meanwhile, there is no relevant limitation on the aspect ratio of the 3D structure when the calcium copper titanate film is deposited on the surface of the 3D structure.

In some possible implementations, the forming the layered deposition structure on the substrate includes:
step 1, placing the substrate in an atomic layer deposition reaction chamber;
step 2, alternately introducing a Ti-containing precursor and an oxygen-containing precursor into the atomic layer deposition reaction chamber, to deposit the titanium dioxide layer on the substrate;
step 3, alternately introducing a Cu-containing precursor and an oxygen-containing precursor into the atomic layer deposition reaction chamber, to deposit the copper oxide layer on the titanium dioxide layer;
step 4, alternately introducing a Ca-containing precursor and an oxygen-containing precursor into the atomic layer deposition reaction chamber, to deposit the calcium oxide or calcium carbonate layer on the copper oxide layer; and
step 5, circularly executing steps 2 to 4 N times to obtain the layered deposition structure.

In some possible implementations, the forming the layered deposition structure on the substrate includes:
step 1, placing the substrate in a chemical vapor deposition reaction chamber;
step 2, simultaneously introducing a Ti-containing precursor and an oxygen-containing precursor into the chemical vapor deposition reaction chamber, to deposit the titanium dioxide layer on the substrate;
step 3, simultaneously introducing a Cu-containing precursor and an oxygen-containing precursor into the chemical vapor deposition reaction chamber, to deposit the copper oxide layer on the titanium dioxide layer;
step 4, simultaneously introducing a Ca-containing precursor and an oxygen-containing precursor into the chemical vapor deposition reaction chamber, to deposit the calcium oxide or calcium carbonate layer on the copper oxide layer; and
step 5, circularly executing steps 2 to 4 N times to obtain the layered deposition structure.

In some possible implementations, the oxygen-containing precursor includes at least one of oxygen, ozone, water vapor, nitrous oxide, plasma of oxygen, plasma of ozone, plasma of water, and plasma of nitrous oxide.

In some possible implementations, the forming the layered deposition structure on the substrate includes:
depositing the titanium dioxide layer, the copper oxide layer, the calcium oxide or calcium carbonate layer, and an oxide layer of a doped element on the substrate.

In some possible implementations, the oxide layer of the doped element is deposited by using a chemical vapor deposition process or an atomic layer deposition process.

In some possible implementations, the oxide layer of the doped element is deposited on a surface of at least one of the following:
the substrate, the titanium dioxide layer, the copper oxide layer, and the calcium oxide or calcium carbonate layer.

In some possible implementations, the doped element includes at least one of Al, Nb, Sb, Zn, Pr, Sr, Fe, Ni, Y, B, Te, Co, Zr, Ga, La, Mg, Sm, Mn, Sc, Ba.

In some possible implementations, the method further includes:
preparing a buffer layer on the substrate, where the buffer layer includes at least one of silicon oxide, silicon nitride, lead zirconate titanate and barium titanate;
the forming the layered deposition structure on the substrate includes:
   depositing the titanium dioxide layer, the copper oxide layer, and the calcium oxide or calcium carbonate layer on the buffer layer.

In some possible implementations, an annealing time of the annealing treatment ranges between 30 seconds and 96 hours.

In some possible implementations, a thickness of the calcium copper titanate film is between 1 nanometer and 100 micrometers.

In some possible implementations, the substrate is provided with a 3D structure, and the titanium dioxide layer, the copper oxide layer, and the calcium oxide or calcium carbonate layer cover the 3D structure.

Therefore, according to a calcium copper titanate film preparation method and a calcium copper titanate film of an embodiment of the present application, the calcium copper titanate film has excellent step coverage, film thickness uniformity and film continuity, and is particularly suitable for a high aspect ratio structure, and further an oxide layer of a doped element may be deposited in the process of preparing the calcium copper titanate film, thereby reducing dielectric loss of the calcium copper titanate film and improving performance; and meanwhile, there is no relevant limitation on the aspect ratio of the 3D structure when the calcium copper titanate film is deposited on the surface of the 3D structure.

### BRIEF DESCRIPTION OF THE DRAWINGS

FIG. 1 is a schematic flowchart of a calcium copper titanate film preparation method according to an embodiment of the present application.
FIG. 2 is a schematic diagram of a forming process of a calcium copper titanate film according to an embodiment of the present application.
FIG. 3 is a schematic diagram of another forming process of a calcium copper titanate film according to an embodiment of the present application.
FIG. 4 is a schematic diagram of a preparation process of a calcium copper titanate film according to an embodiment of the present application.

### DESCRIPTION OF EMBODIMENTS

Technical solutions in embodiments of the present application will be described hereinafter in conjunction with the accompanying drawings.

A CCTO film described in an embodiment of the present application has an ultra-high dielectric constant (about 10⁴-10⁵) and a wide frequency and temperature stability range. Preparation of a high-quality CCTO film is of great significance to miniaturization of an electronic device (for example, a capacitor).

At present, a process for preparing the CCTO film mainly includes MOCVD, PLD, RF magnetron sputtering, a sol-gel method, or the like. the CCTO film may be deposited on a surface of a 3D structure such as a via, a trench, a pillar, or the like only by a MOCVD process, of which a basic principle is to simultaneously introduce a gaseous precursor containing Ca, Cu and Ti, and oxygen into a reaction chamber, and react at a high temperature so as to generate the CCTO film. However, the deposition of the CCTO thin film on the surface of 3D structure such as the via, the trench, the pillar or the like by the MOCVD process has certain limitations on an aspect ratio of the 3D structure, which generally requires to be less than 10, otherwise it is difficult to control film thickness uniformity of a film. Under this background, the present application provides a CCTO film preparation method, and the CCTO film prepared by the method has excellent step coverage, film thickness uniformity and film continuity, and is especially suitable for a high aspect ratio structure; and further, the method may also include doping the CCTO film to further reduce dielectric loss of the film and improve performance.

Specifically, by using a chemical vapor deposition (CVD) process or an atomic layer deposition (ALD) process, at least one titanium dioxide (TiO₂) layer, at least one copper oxide (CuO) layer and at least one calcium oxide (CaO) or calcium carbonate (CaCO₃) layer are deposited on a substrate to obtain a layered deposition structure, and then the layered deposition structure is subjected to high-temperature annealing treatment in an oxygen-containing atmosphere to obtain a calcium copper titanate film.

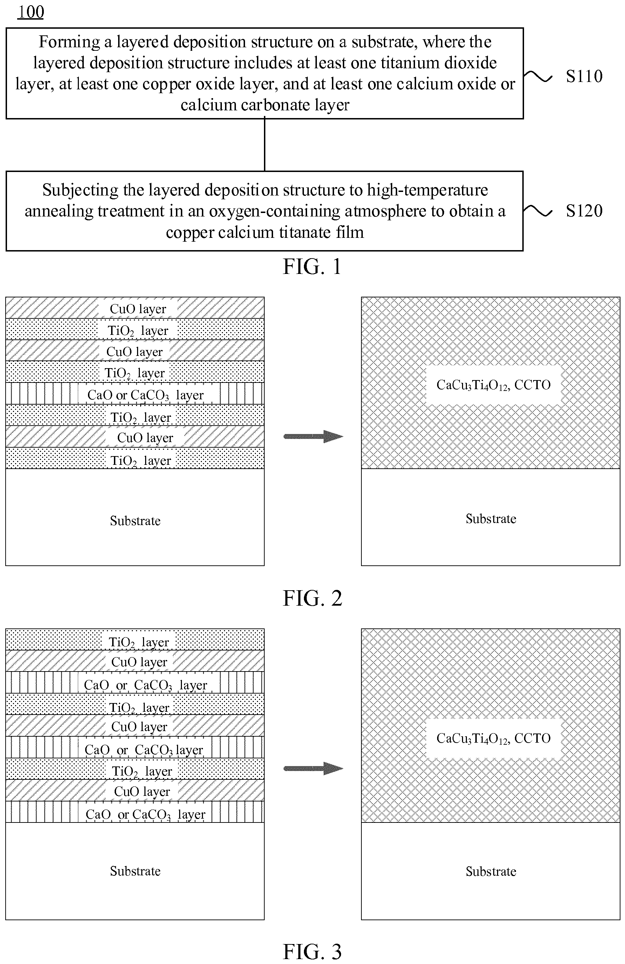

Hereinafter, a calcium copper titanate film preparation method according to an embodiment of the present application will be described with reference to FIGS. 1 to 4. It should be understood that FIGS. 1 to 4 show main steps or operations of the preparation method of the embodiment of the present application, however, these steps or operations are merely examples, and the embodiment of the present application may also perform other operations or variations of various operations of FIGS. 1 to 4. In addition, various steps in a method embodiment of the present application may also be performed in orders different from those as described in the method embodiment, and it is possible that not all operations in the method embodiment are performed.

FIG. 1 is a schematic flowchart of a calcium copper titanate film preparation method 100 according to an embodiment of the present application. As shown in FIG. 1, the preparation method 100 may include:
S110, forming a layered deposition structure on a substrate, where the layered deposition structure includes at least one titanium dioxide layer, at least one copper oxide layer, and at least one calcium oxide or calcium carbonate layer; and
S120, subjecting the layered deposition structure to high-temperature annealing treatment in an oxygen-containing atmosphere to obtain a calcium copper titanate film.

Optionally, the substrate may be a silicon wafer, for example, a silicon wafer of a crystal orientation 100.

It should be noted that thicknesses of the titanium dioxide layer, the copper oxide layer, and the calcium oxide or calcium carbonate layer deposited on the substrate may be nanometer-scaled, and a thickness of the prepared calcium copper titanate film may also be nanometer-scaled.

In S110, the titanium dioxide layer, the copper oxide layer, and the calcium oxide or calcium carbonate layer may be deposited on part or all of the surface (such as an upper surface) of the substrate to obtain the layered deposition structure.

Optionally, in S110, the titanium dioxide layer, the copper oxide layer, and the calcium oxide or calcium carbonate layer may be deposited on the substrate by using an atomic layer deposition process or a chemical vapor deposition process.

It should be noted that by using the atomic layer deposition process, substances may be plated on a surface of the substrate or a base substrate layer by layer in a monoatomic (including a signal atom) manner by alternately introducing two different precursors into the reaction chamber for surface adsorption reaction.

For example, a substrate or a base substrate is placed in an ALD reaction chamber, and introducing H₂O into the ALD reaction chamber as an oxygen(O)-containing precursor to perform surface adsorption reaction is equivalent to depositing a layer containing an oxygen atom on the substrate or the base substrate; similarly, introducing TiCl₄ into the ALD reaction chamber as a Ti-containing precursor is equivalent to depositing a layer containing a Ti atom on the substrate or the base substrate; and further, H₂O and TiCl₄ are alternately introduced, the O-containing precursor and the Ti-containing precursor may be plated on the surface of the substrate or base substrate layer by layer in a monoatomic (including a signal atom) manner, and then are grown into a TiO₂ layer. Similarly, an O-containing precursor and a Cu-containing precursor may be plated on the surface of the substrate or the base substrate layer by layer in a monatomic manner, and then are grown into a CuO layer. Similarly, an O-containing precursor and a Ca-containing precursor may be plated on the surface of the substrate or the base substrate layer by layer in a monoatomic manner, and are then grown into a CaO or CaCO₃ layer.

Compared with the current calcium copper titanate film preparation method by MOCVD, the calcium copper titanate film prepared by the atomic layer deposition process has advantages of high film quality, excellent step coverage, good film thickness uniformity, accurate thickness control and the like; and meanwhile, as for depositing the calcium copper titanate film on the surface of the 3D structure by the atomic layer deposition process, an aspect ratio of the 3D structure is not limited, and therefore the 3D structure may be a 3D structure with a smaller aspect ratio or a 3D structure with a larger aspect ratio.

Therefore, by using the atomic layer deposition process, the titanium dioxide layer, the copper oxide layer, and the calcium oxide or calcium carbonate layer are deposited on the substrate, and then the high-temperature annealing treatment is performed in the oxygen-containing atmosphere to obtain the calcium copper titanate film. Such calcium copper titanate film has high quality, excellent step coverage, and good film thickness uniformity, and a thickness of the calcium copper titanate film may be accurately controlled; also, there is no relevant limitation on the aspect ratio of the 3D structure when the calcium copper titanate film is deposited on the surface of the 3D structure.

It should be noted that by using the chemical vapor deposition process, a large deposition rate may be achieved by simultaneously introducing two different precursors into the reaction chamber to deposit the material; also, there is no relevant limitation on the aspect ratio of the 3D structure when the calcium copper titanate film is deposited on the surface of the 3D structure.

Therefore, by using the chemical vapor deposition process, the titanium dioxide layer, the copper oxide layer, and the calcium oxide or calcium carbonate layer are deposited on the substrate, and then the high-temperature annealing treatment is performed in the oxygen-containing atmosphere to obtain the calcium copper titanate film, so that a deposition rate may be improved; and meanwhile, there is no relevant limitation on the aspect ratio of the 3D structure when the calcium copper titanate film is deposited on the surface of the 3D structure.

Optionally, the substrate is provided with a 3D structure. Specifically, the titanium dioxide layer, the copper oxide layer, and the calcium oxide or calcium carbonate layer may be deposited on the surface of the 3D structure, in other words, the titanium dioxide layer, the copper oxide layer, and the calcium oxide or calcium carbonate layer cover the 3D structure.

For example, the 3D structure is a via, a trench, a pillar, or the like.

Optionally, the 3D structure has a large aspect ratio, for example, greater than 10.

It should be noted that the layered deposition structure obtained through S110 is the titanium dioxide layer, the copper oxide layer, and the calcium oxide or calcium carbonate layer deposited on the substrate, and finally it is the titanium dioxide layer, the copper oxide layer, and the calcium oxide or calcium carbonate layer in the layered deposition structure that are subjected to the high-temperature annealing treatment in the oxygen-containing atmosphere to obtain the calcium copper titanate film.

Optionally, in an embodiment of the present application, a molar ratio of a Ca element, a Cu element and a Ti element in the layered deposition structure is equal to or close to 1:3:4. In other words, the molar ratio of the Ca element, the Cu element and the Ti element in all layers (all of the titanium dioxide layer, the copper oxide layer, and the calcium oxide or calcium carbonate layer) deposited on the substrate is equal to or close to 1:3:4.

It should be noted that in order to better perform a chemical reaction in the high-temperature annealing process, in a deposition process of each layer (the titanium dioxide layer, the copper oxide layer, and the calcium oxide or calcium carbonate layer), a ratio of a certain element of Ca, Cu and Ti in the layered deposition structure may be slightly greater by controlling a precursor ratio of the corresponding element, or by controlling a thickness of the layer where the corresponding element is located; for example, in the deposition process of each layer, a ratio of a Cu element may be slightly greater by controlling and increasing a ratio of a Cu-containing precursor, or by controlling and increasing a thickness of CuO layer.

Optionally, according to the embodiment of the present application, in the layered deposition structure, a deposition sequence and deposition thickness of the titanium dioxide layer, the copper oxide layer, and the calcium oxide or calcium carbonate layer may be flexibly set according to actual needs. That is, in the layered deposition structure, deposition thicknesses of different titanium dioxide layers may be the same or different; deposition thicknesses of different copper oxide layers may be the same or different; deposition thicknesses of different calcium oxide or calcium carbonate layers may be the same or different; similarly, deposition thicknesses of the titanium dioxide layer and the copper oxide layer may be the same or different, deposition thicknesses of the titanium dioxide layer and the calcium oxide or calcium carbonate layer may be the same or different, and deposition thicknesses of the copper oxide layer and the calcium oxide or calcium carbonate layer may be the same or different.

Optionally, according to the embodiment of the present application, in the layered deposition structure, the titanium dioxide layer, the copper oxide layer and the calcium oxide or calcium carbonate layer are alternately deposited in a non-cyclic manner or alternately deposited in a partial cyclic manner.

Optionally, the titanium dioxide layer and the copper oxide layer are deposited on the substrate in a cyclic deposition manner, and the calcium oxide or calcium carbonate layer is disposed between the titanium dioxide layers and/or the copper oxide layers.

It should be noted that the calcium oxide or calcium carbonate layer may be located between the two titanium dioxide layers, or between the two copper oxide layers, or between the titanium dioxide layer and the copper oxide layer, which is not limited in the present application.

For example, as shown in FIG. 2, eight layers are sequentially deposited on an upper surface of the substrate, and together form a layered deposition structure, and from the substrate to the top the eight layers sequentially are: a first layer is a TiO₂ layer, a second layer is a CuO layer, a third layer is a TiO₂ layer, a fourth layer is a CaO or CaCO₃ layer, a fifth layer is a TiO₂ layer, a sixth layer is a CuO layer, a seventh layer is a TiO₂ layer, and an eighth layer is a CuO layer. As shown in FIG. 2, the layered deposition structure is subjected to high temperature annealing treatment in an oxygen-containing atmosphere to obtain a calcium copper titanate (CaCu₃Ti₄O₁₂, CCTO) film. That is, the structure shown in FIG. 2 may be regarded as non-cyclic alternate deposition or partial cyclic alternate deposition, that is, circularly depositing the titanium dioxide layer and the copper oxide layer is used in part of the layered structure.

Optionally, according to other embodiments of the present application, in the layered deposition structure, the titanium dioxide layer, the copper oxide layer, and the calcium oxide or calcium carbonate layer are deposited in a cyclic deposition manner. That is, in S 110, the titanium dioxide layer, the copper oxide layer, and the calcium oxide or calcium carbonate layer may be alternately deposited in a cyclic manner.

Optionally, when a cycle number N of the cyclic deposition manner is equal to 1 (N=1), a sequence of the depositing the titanium dioxide layer, the copper oxide layer, and the calcium oxide or calcium carbonate layer on the substrate is as follows:
a titanium dioxide layer, a copper oxide layer, and a calcium oxide or calcium carbonate layer; or
a titanium dioxide layer, a calcium oxide or calcium carbonate layer, and a copper oxide layer; or
a copper oxide layer, a titanium dioxide layer, and a calcium oxide or calcium carbonate layer; or
a copper oxide layer, a calcium oxide or calcium carbonate layer, and a titanium dioxide layer; or
a calcium oxide or calcium carbonate layer, a titanium dioxide layer, and a copper oxide layer; or
a calcium oxide or calcium carbonate layer, a copper oxide layer, and a titanium dioxide layer.

For example, as shown in FIG. 3, nine layers are sequentially deposited on an upper surface of the substrate, and together form a layered deposition structure, and from the substrate to the top the nine layers sequentially are: a first layer is a TiO₂ layer, a second layer is a CuO layer, a third layer is a CaO or CaCO₃ layer, a fourth layer is a TiO₂ layer, a fifth layer is a CuO layer, a sixth layer is a CaO or CaCO₃ layer, a seventh layer is a TiO₂ layer, an eighth layer is a CuO layer, and a ninth layer is a CaO or CaCO₃ layer. As shown in FIG. 3, the layered deposition structure is subjected to high temperature annealing treatment in an oxygen-containing atmosphere to obtain a calcium copper titanate (CaCu₃Ti₄O₁₂, CCTO) film. That is, the structure shown in FIG. 3 may be regarded as cyclic alternate deposition, that is, cyclically depositing the titanium dioxide layer, the copper oxide layer, and the calcium oxide or calcium carbonate layer is used.

As an example, if a cycle number N of the cyclic deposition manner is equal to 1 (N=1), a sequence of the depositing the titanium dioxide layer, the copper oxide layer, and the calcium oxide or calcium carbonate layer on the substrate is the titanium dioxide layer, the copper oxide layer, and the calcium oxide or calcium carbonate layer, and a deposition process is an atomic layer deposition process. S110 may specifically be:
step 1, placing the substrate in an atomic layer deposition reaction chamber;
step 2, alternately introducing a Ti-containing precursor and an oxygen-containing precursor into the atomic layer deposition reaction chamber, to deposit the titanium dioxide layer on the substrate;
step 3, alternately introducing a Cu-containing precursor and an oxygen-containing precursor into the atomic layer deposition reaction chamber, to deposit the copper oxide layer on the titanium dioxide layer;
step 4, alternately introducing a Ca-containing precursor and an oxygen-containing precursor into the atomic layer deposition reaction chamber, to deposit the calcium oxide or calcium carbonate layer on the copper oxide layer; and
step 5, circularly executing steps 2 to 4 N times to obtain the layered deposition structure.

As another example, if a cycle number N of the cyclic deposition manner is equal to 1 (N=1), a sequence of the depositing the titanium dioxide layer, the copper oxide layer, and the calcium oxide or calcium carbonate layer on the substrate is the titanium dioxide layer, the copper oxide layer, and the calcium oxide or calcium carbonate layer, and a deposition process is a chemical vapor deposition process. S110 may specifically be:
step 1, placing the substrate in a chemical vapor deposition reaction chamber;
step 2, simultaneously introducing a Ti-containing precursor and an oxygen-containing precursor into the chemical vapor deposition reaction chamber, to deposit the titanium dioxide layer on the substrate;
step 3, simultaneously introducing a Cu-containing precursor and an oxygen-containing precursor into the chemical vapor deposition reaction chamber, to deposit the copper oxide layer on the titanium dioxide layer;
step 4, simultaneously introducing a Ca-containing precursor and an oxygen-containing precursor into the chemical vapor deposition reaction chamber, to deposit the calcium oxide or calcium carbonate layer on the copper oxide layer; and
step 5, circularly executing steps 2 to 4 N times to obtain the layered deposition structure.

It should be noted that in the foregoing two examples, if N=0, the layered deposition structure may be obtained by performing the foregoing steps 1 to 4.

It should be noted that in the foregoing two examples, the surface (for example, the upper surface) of the substrate on which the titanium dioxide layer, the copper oxide layer, and the calcium oxide or calcium carbonate layer need to be deposited may be exposed to the chemical vapor deposition reaction chamber, while other surfaces of the substrate may be hidden, so that the titanium dioxide layer, the copper oxide layer, and the calcium oxide or calcium carbonate layer are only deposited on the exposed surface.

It should also be noted that factors such as a temperature and reaction rate of the chemical vapor deposition reaction chamber may be adjusted after step 2 ends, and then step 3 is started. Similarly, factors such as a temperature and reaction rate of the chemical vapor deposition reaction chamber may be adjusted after step 3 ends, and then step 4 is started.

Optionally, in the foregoing two examples, the oxygen-containing precursor includes at least one of oxygen (O₂), ozone (O₃), water vapor (H₂O), nitrous oxide (N₂O), plasma of oxygen, plasma of ozone, plasma of water, and plasma of nitrous oxide.

In the foregoing two examples, the Ti-containing precursor may be, for example, titanium tetrachloride (TiCl₄), and the Cu-containing precursor may be, for example, bis(hexafluoroacetoacetonato) copper (Cu(hfac)₂, (hfac=hexafluoroacetoacetonato)). If the calcium oxide layer is deposited on the copper oxide layer in step 4, the Ca-containing precursor may be, for example, bis(1,2,4-triisopropylcyclopentadienyl) calcium (Ca(Cp³ⁱ)₂, (CP³ⁱ = 1,2,4-triisopropylcyclopentenyl)). If the calcium carbonate layer is deposited on the copper oxide layer in step 4, the Ca-containing precursor may be, for example, bis(2,2,6,6,-tetramethyl-3,5-heptanedionato) calcium (Ca(thd)₂, (thd = 2,2,6,6-tetramethyl-3,5-heptadionato)).

It should be noted that in the foregoing two examples, description is made by only an example where the sequence of the depositing the titanium dioxide layer, the copper oxide layer, and the calcium oxide or calcium carbonate layer on the substrate is the titanium dioxide layer, the copper oxide layer, and the calcium oxide or calcium carbonate layer when a cycle number N of the cyclic deposition manner is equal to 1 (N=1), and other cycle sequences also meet the foregoing examples, but will not be repeated here for the sake of brevity.

Optionally, in the embodiment of the present application, the layered deposition structure obtained through S110 further includes an oxide layer of at least one doped element. That is, in S110, by using a chemical vapor deposition possess or an atomic layer deposition process, the titanium dioxide layer, the copper oxide layer, the calcium oxide or calcium carbonate layer and the oxide layer of the doped element are alternately deposited on the substrate, to obtain the layered deposition structure. In other words, the oxide layer of the doped element is deposited on the substrate by using the chemical vapor deposition process or the atomic layer deposition process.

Optionally, the oxide layer of the doped element is deposited on a surface of at least one of the following:
the substrate, the titanium dioxide layer, the copper oxide layer, and the calcium oxide or calcium carbonate layer.

Optionally, the doped element includes at least one of the following elements: aluminum (Al), niobium (Nb), antimony (Sb), zinc (Zn), praseodymium (Pr), strontium (Sr), iron (Fe), nickel (Ni), yttrium (Y), boron (B), tellurium (Te), cobalt (Co), zirconium (Zr), gallium (Ga), lanthanum (La), magnesium (Mg), samarium (Sm), manganese (Mn), scandium (Sc), and barium (Ba).

It should be noted that when the doped element includes a plurality of the foregoing elements, the oxide layer of the doped element may be a layer composed of a compound. For example, when the doped element includes Al and Fe, the oxide layer of the doped element may be a layer composed of a compound of alumina (Al₂O₃) and iron oxide (Fe₃O₄).

It should be understood that adding an oxide layer of at least one doped element in the layered deposition structure could reduce dielectric loss of the calcium copper titanate film prepared in S120.

Optionally, in the embodiment of the present application, before S110 is performed, a buffer layer including at least one of silicon oxide, silicon nitride, lead zirconate titanate (piezoelectric ceramic transducer, PZT), barium titanate (BaTiO₃) is prepared on the substrate. At this time, S110 may specifically be: alternately depositing the titanium dioxide layer, the copper oxide layer, and the calcium oxide or calcium carbonate layer on the buffer layer by using the chemical vapor deposition process or the atomic layer deposition process to obtain the layered deposition structure.

Optionally, the buffer layer may be prepared on the substrate by using a thermal oxidation method.

It should be understood that adding the foregoing buffer layer on the substrate may enable the titanium dioxide layer, the copper oxide layer, and the calcium oxide or calcium carbonate layer to be better deposited on the substrate. Since the substrate is usually a silicon wafer, and lattice matching of the silicon wafer with the titanium dioxide layer, the copper oxide layer and the calcium oxide or calcium carbonate layer is poor, deposition effect will be affected if the foregoing layers are directly deposited on the substrate.

Therefore, adding buffer layer may make the lattice matching of the titanium dioxide layer, the copper oxide layer and the calcium oxide or calcium carbonate layer with the substrate better, and further make quality of the calcium copper titanate film better.

Optionally, in the embodiment of the present application, the substrate for depositing the titanium dioxide layer, the copper oxide layer, and the calcium oxide or calcium carbonate layer is prepared before S110 is performed.

It should be noted that in S120, when the layered deposition structure is subjected to the high-temperature annealing treatment in the oxygen-containing atmosphere, the substrate to which the layered deposition structure is connected may also be placed in the oxygen-containing atmosphere.

Optionally, in S120, a high-temperature annealing temperature ranges between 500°C and 1300°C and a high-temperature annealing time ranges between 30 seconds and 96 hours.

It should be noted that during the high-temperature annealing, an annealing temperature may be varied, for example, a temperature step may be adjusted to rise or fall according to the reaction.

It should be noted that in S120, the layered deposition structure obtained in S110 needs to be put into a furnace tube, in which oxygen or a mixed gas of oxygen and other gases is introduced, and the temperature and time of high-temperature annealing are controlled at the same time, so as to obtain the calcium copper titanate film.

Optionally, a thickness of the calcium copper titanate film obtained through S120 is between 1 nanometer and 100 micrometers.

Optionally, according to the embodiment of the present application, if in S110 the titanium dioxide layer, the copper oxide layer and the calcium oxide layer are deposited on the substrate by the chemical vapor deposition process or the atomic layer deposition process to obtain the layered deposition structure, the calcium copper titanate film is obtained by the following chemical Reaction 1 in S120. If in S110 the titanium dioxide layer, the copper oxide layer and the calcium carbonate layer are deposited on the substrate by using the chemical vapor deposition process or the atomic layer deposition process to obtain the layered deposition structure, the calcium copper titanate film is obtained by the following chemical Reaction 2 in S120.

4TiO₂+3CuO+CaO → CaCu₃Ti₄O₁₂ Reaction 1

4TiO₂+3CuO+CaCO₃ → CaCu₃Ti₄O12+CO₂ Reaction 2

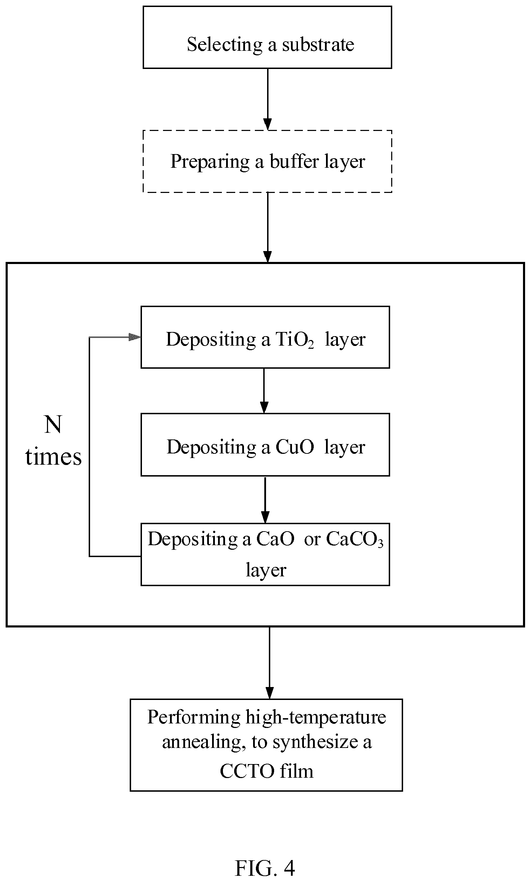

Optionally, as one embodiment, a calcium copper titanate film may be prepared according to the flowchart shown in FIG. 4. Specifically, as shown in FIG. 4, in a process of preparing a calcium copper titanate film:
step 1, a substrate is selected.

It should be noted that the substrate may be a prepared finished substrate or a substrate prepared according to actual requirements.

Optionally, there are 3D structures such as a via, a trench, a pillar, or the like on the substrate.

Optionally, step 2, a buffer layer is prepared.

In particular, the buffer layer is prepared on the substrate.

Optionally, the buffer layer includes at least one of silicon oxide, silicon nitride, lead zirconate titanate, and barium titanate.

Step 3: a TiO₂ layer, a CuO layer and a CaO or CaCO₃ layer are cyclically deposited, where a cycle number is N.

Optionally, in step 3, a TiO₂ layer, a CuO layer, and a CaO or CaCO₃ layer may be cyclically deposited by using an atomic layer deposition process or a chemical vapor deposition process to obtain a layered deposition structure.

It should be understood that step 3 is performed in the reaction chamber.

It should be noted that if step 2 exists, the first TiO₂ layer is deposited on the buffer layer in step 3; if step 2 does not exist, the first TiO₂ layer is deposited on the substrate in step 3.

Step 4, high-temperature annealing is performed to synthesize a CCTO film.

Specifically, a layered deposition structure obtained in step 3 is subjected to the high-temperature annealing treatment in the oxygen-containing atmosphere to obtain the CCTO film.

Optionally, step 4 may be carried out in a furnace tube or in a rapid thermal annealing (RTA) furnace.

It should be noted that when step 4 is performed in the furnace tube, a time required for high-temperature annealing is longer, for example, 96 hours; however, when step 4 is performed in a rapid annealing furnace, a time required for high-temperature annealing is shorter, for example, 30 seconds.

Optionally, a high-temperature annealing temperature ranges between 500°C and 1300°C and a high-temperature annealing time ranges between 30 seconds and 96 hours.

Optionally, if the TiO₂ layer, the CuO layer and the CaO layer are circularly deposited on the substrate to obtain the layered deposition structure in step 3, the calcium copper titanate film is obtained by the foregoing Reaction 1 in step 4. If the TiO₂ layer, the CuO layer and the CaCO₃ layer are deposited on the substrate to obtain the layered deposition structure in step 3, the calcium copper titanate film is obtained by the foregoing Reaction 2 in step 4.

Therefore, in the embodiment of the present application, the calcium copper titanate film has excellent step coverage, film thickness uniformity and film continuity, and is particularly suitable for a high aspect ratio structure, and further the oxide layer of the doped element may be deposited in the process of preparing the calcium copper titanate film, thereby reducing dielectric loss and improving performance.

A calcium copper titanate film preparation method of the present application will be further described below with reference to a specific embodiment. In this embodiment, a total thickness of each oxide layer is respectively: 84.6 nm for TiO₂, 37.8 nm for CuO, 16.8 nm for CaO.

Step 1, a silicon wafer of a crystal orientation (100) is selected as a substrate. A 10 nm-thick silicon oxide is grown on a wafer surface as a buffer layer by using a thermal oxidation method.

Step 2a, the silicon wafer is placed in an ALD reaction chamber, H₂O and TiCl₄ are alternately and circularly introduced as an O-containing precursor and a Ti-containing precursor, respectively, to grow 8.46 nm-thick TiO₂.

Step 2b, H₂O and Cu (hfac)₂ (hfac = hexafluorocetoacetonato) are alternately and circularly introduced into the ALD reaction chamber as an O-containing precursor and a Cu-containing precursor, respectively, to grow 3.78 nm-thick CuO.

Step 2c, H₂O and Ca (Cp³ⁱ)₂ (Cp³ⁱ = 1,2,4-triisopropylcyclopentadienyl) are alternately and cyclically introduced into the ALD reaction chamber as an O-containing precursor and a Ca-containing precursor, respectively, to grow 1.68 nm-thick CaO.

Steps 2a, 2b, 2c are repeated for a total of 10 cycles.

Step 3, the silicon wafer with a layered oxide is placed into a furnace tube, in which a mixed gas of hydrogen and oxygen is introduced, and annealed at 1100°C for 4 hours to obtain a calcium copper titanate film.

Optionally, an embodiment of the present application provides a calcium copper titanate film, which is prepared by the foregoing calcium copper titanate film preparation method 100.

A person skilled in the art can understand that preferred embodiments of the present application are described in detail above with reference to the accompanying drawings. However, the present application is not limited to specific details in the foregoing embodiments. Within the technical concept of the present application, the technical solution of the present application may carry out a variety of simple variants, all of which are within the scope of protection of the present application.

In addition, it should be noted that various specific technical features described in the foregoing specific embodiments may be combined in any suitable manner under the condition of no contradiction. In order to avoid unnecessary repetition, various possible combination ways will not be separately described in the present application.

In addition, any combination may be made between various embodiments of the present application without departing from the idea of the present application, it should also be regarded as the disclosure of the present application.

## Claims

1. A calcium copper titanate film preparation method, comprising:
forming a layered deposition structure on a substrate, wherein the layered deposition structure comprises at least one titanium dioxide layer, at least one copper oxide layer, and at least one calcium oxide or calcium carbonate layer; and
subjecting the layered deposition structure to annealing treatment in an oxygen-containing atmosphere to obtain a calcium copper titanate film, wherein an annealing temperature of the annealing treatment ranges between 500°C and 1300°C;
wherein the forming the layered deposition structure on the substrate comprises:
respectively depositing the titanium dioxide layer, depositing the copper oxide layer, and depositing the calcium oxide or calcium carbonate layer on the substrate in a cyclic deposition manner.

2. The preparation method according to claim 1, wherein a molar ratio of a Ca element, a Cu element and a Ti element in the layered deposition structure is equal to or close to 1:3:4.

3. The preparation method according to claim 1 or 2, wherein the forming the layered deposition structure on the substrate comprises:
depositing the titanium dioxide layer, the copper oxide layer, and the calcium oxide or calcium carbonate layer on the substrate by using an atomic layer deposition process or a chemical vapor deposition process.

4. The preparation method according to claim 1, wherein the forming the layered deposition structure on the substrate comprises:
step 1, placing the substrate in an atomic layer deposition reaction chamber;
step 2, alternately introducing a Ti-containing precursor and an oxygen-containing precursor into the atomic layer deposition reaction chamber, to deposit the titanium dioxide layer on the substrate;
step 3, alternately introducing a Cu-containing precursor and an oxygen-containing precursor into the atomic layer deposition reaction chamber, to deposit the copper oxide layer on the titanium dioxide layer;
step 4, alternately introducing a Ca-containing precursor and an oxygen-containing precursor into the atomic layer deposition reaction chamber, to deposit the calcium oxide or calcium carbonate layer on the copper oxide layer; and
step 5, circularly executing steps 2 to 4 N times to obtain the layered deposition structure.

5. The preparation method according to claim 1, wherein the forming the layered deposition structure on the substrate comprises:
step 1, placing the substrate in a chemical vapor deposition reaction chamber;
step 2, simultaneously introducing a Ti-containing precursor and an oxygen-containing precursor into the chemical vapor deposition reaction chamber, to deposit the titanium dioxide layer on the substrate;
step 3, simultaneously introducing a Cu-containing precursor and an oxygen-containing precursor into the chemical vapor deposition reaction chamber, to deposit the copper oxide layer on the titanium dioxide layer;
step 4, simultaneously introducing a Ca-containing precursor and an oxygen-containing precursor into the chemical vapor deposition reaction chamber, to deposit the calcium oxide or calcium carbonate layer on the copper oxide layer; and
step 5, circularly executing steps 2 to 4 N times to obtain the layered deposition structure.

6. The preparation method according to claim 4 or 5, wherein the oxygen-containing precursor comprises at least one of oxygen, ozone, water vapor, nitrous oxide, plasma of oxygen, plasma of ozone, plasma of water, and plasma of nitrous oxide.

7. The preparation method according to claim 1 or 2, wherein the forming the layered deposition structure on the substrate comprises:
depositing the titanium dioxide layer, the copper oxide layer, the calcium oxide or calcium carbonate layer, and an oxide layer of a doped element on the substrate.

8. The preparation method according to claim 7, wherein the oxide layer of the doped element is deposited by using a chemical vapor deposition process or an atomic layer deposition process.

9. The preparation method according to claim 7 or 8, wherein the oxide layer of the doped element is deposited on a surface of at least one of
the substrate, the titanium dioxide layer, the copper oxide layer, and the calcium oxide or calcium carbonate layer.

10. The preparation method according to any one of claims 7 to 9, wherein the doped element comprises at least one of Al, Nb, Sb, Zn, Pr, Sr, Fe, Ni, Y, B, Te, Co, Zr, Ga, La, Mg, Sm, Mn, Sc, Ba.

11. The preparation method according to any one of claims 1 to 10, further comprising:
preparing a buffer layer on the substrate, wherein the buffer layer comprises at least one of silicon oxide, silicon nitride, lead zirconate titanate and barium titanate;
the forming the layered deposition structure on the substrate comprises:
depositing the titanium dioxide layer, the copper oxide layer, and the calcium oxide or calcium carbonate layer on the buffer layer.

12. The preparation method according to any one of claims 1 to 11, wherein an annealing time of the annealing treatment ranges between 30 seconds and 96 hours; and/or a thickness of the calcium copper titanate film is between 1 nanometer and 100 micrometers.

13. The preparation method according to any one of claims 1 to 12, wherein the substrate is provided with a 3D structure, and the titanium dioxide layer, the copper oxide layer, and the calcium oxide or calcium carbonate layer cover the 3D structure.

## Patentansprüche

1. Verfahren zur Herstellung eines Calcium-Kupfer-Titanat-Films, umfassend:
Bilden einer geschichteten Abscheidungsstruktur auf einem Substrat, wobei die geschichtete Abscheidungsstruktur mindestens eine Titandioxidschicht, mindestens eine Kupferoxidschicht und mindestens eine Calciumoxid- oder Calciumcarbonatschicht umfasst; und
Unterziehen der geschichteten Abscheidungsstruktur einer Glühbehandlung in einer sauerstoffhaltigen Atmosphäre, um einen Calcium-Kupfer-Titanat-Film zu erhalten, wobei eine Glühtemperatur der Glühbehandlung zwischen 500°C und 1300°C liegt;
wobei das Ausbilden der geschichteten Abscheidungsstruktur auf dem Substrat umfasst:
Abscheiden der Titandioxidschicht, Abscheiden der Kupferoxidschicht bzw. Abscheiden der Calciumoxid- oder Calciumcarbonatschicht auf dem Substrat in einer zyklischen Abscheidungsweise.

2. Herstellungsverfahren nach Anspruch 1, wobei das molare Verhältnis eines Ca-Elements, eines Cu-Elements und eines Ti-Elements in der geschichteten Abscheidungsstruktur gleich oder nahe bei 1 : 3 : 4 ist.

3. Herstellungsverfahren nach Anspruch 1 oder 2, wobei das Ausbilden der geschichteten Abscheidungsstruktur auf dem Substrat umfasst:
Abscheiden der Titandioxidschicht, der Kupferoxidschicht und der Kalziumoxid- oder Calciumkarbonatschicht auf dem Substrat unter Verwendung eines atomaren Schichtabscheidungsverfahrens oder eines chemischen Gasphasenabscheidungsverfahrens.

4. Herstellungsverfahren nach Anspruch 1, wobei das Ausbilden der geschichteten Abscheidungsstruktur auf dem Substrat umfasst:
Schritt 1, Anordnen des Substrats in einer atomaren Schichtabscheidungsreaktionskammer;
Schritt 2, abwechselndes Einführen eines Ti-enthaltenden Vorläufers und eines Sauerstoff enthaltenden Vorläufers in die atomare Schichtabscheidungsreaktionskammer, um die Titandioxidschicht auf dem Substrat abzuscheiden;
Schritt 3, abwechselndes Einführen eines Cu-haltigen Vorläufers und eines sauerstoffhaltigen Vorläufers in die Reaktionskammer für die Atomlagenabscheidung, um die Kupferoxidschicht auf der Titandioxidschicht abzuscheiden;
Schritt 4, abwechselndes Einführen eines Ca-haltigen Vorläufers und eines sauerstoffhaltigen Vorläufers in die Reaktionskammer für die Atomlagenabscheidung, um die Calciumoxid- oder Calciumcarbonatschicht auf der Kupferoxidschicht abzuscheiden; und
Schritt 5, zirkuläres Ausführen der Schritte 2 bis 4 N-mal, um die geschichtete Abscheidungsstruktur zu erhalten.

5. Herstellungsverfahren nach Anspruch 1, wobei das Ausbilden der geschichteten Abscheidungsstruktur auf dem Substrat umfasst:
Schritt 1, Platzieren des Substrats in einer Reaktionskammer für die chemische Abscheidung aus der Gasphase;
Schritt 2, gleichzeitiges Einführen eines Ti enthaltenden Vorläufers und eines Sauerstoff enthaltenden Vorläufer in die Reaktionskammer für die chemische Gasphasenabscheidung, um die Titandioxidschicht auf dem Substrat abzuscheiden;
Schritt 3, gleichzeitiges Einführen eines Cu-haltigen Vorläufers und eines sauerstoffhaltigen Vorläufers in die Reaktionskammer für die chemische Gasphasenabscheidung, um die Kupferoxidschicht auf der Titandioxidschicht abzuscheiden;
Schritt 4, gleichzeitiges Einführen eines Ca-haltigen Vorläufers und eines sauerstoffhaltigen Vorläufers in die Reaktionskammer für die chemische Gasphasenabscheidung, um die Calciumoxid- oder Calciumcarbonatschicht auf der Kupferoxidschicht abzuscheiden; und
Schritt 5, kreisförmiges Ausführen der Schritte 2 bis 4 N-mal, um die geschichtete Abscheidungsstruktur zu erhalten.

6. Herstellungsverfahren nach Anspruch 4 oder 5, wobei der sauerstoffhaltige Vorläufer mindestens eines der folgenden Elemente umfasst: Sauerstoff, Ozon, Wasserdampf, Distickstoffoxid, Sauerstoffplasma, Ozonplasma, Wasserplasma und Distickstoffoxidplasma.

7. Herstellungsverfahren nach Anspruch 1 oder 2, wobei das Ausbilden der geschichteten Abscheidungsstruktur auf dem Substrat umfasst:
Abscheiden der Titandioxidschicht, der Kupferoxidschicht, der Calciumoxid- oder Calciumcarbonatschicht und einer Oxidschicht eines dotierten Elements auf dem Substrat.

8. Herstellungsverfahren nach Anspruch 7, wobei die Oxidschicht des dotierten Elements unter Verwendung eines chemischen Gasphasenabscheidungsverfahrens oder eines atomaren Schichtabscheidungsverfahrens abgeschieden wird.

9. Herstellungsverfahren nach Anspruch 7 oder 8, wobei die Oxidschicht des dotierten Elements auf einer Oberfläche des Substrats, der Titandioxidschicht, der Kupferoxidschicht und/oder der Calciumoxid- oder Calciumcarbonatschicht abgeschieden wird.

10. Herstellungsverfahren nach einem der Ansprüche 7 bis 9, wobei das dotierte Element mindestens eines von AI, Nb, Sb, Zn, Pr, Sr, Fe, Ni, Y, B, Te, Co, Zr, Ga, La, Mg, Sm, Mn, Sc, Ba umfasst.

11. Herstellungsverfahren nach einem der Ansprüche 1 bis 10, ferner umfassend:
Herstellen einer Pufferschicht auf dem Substrat, wobei die Pufferschicht mindestens eines von Siliziumoxid, Siliziumnitrid, Bleizirkonattitanat und Bariumtitanat umfasst;
das Bilden der geschichteten Abscheidungsstruktur auf dem Substrat umfasst:
Abscheiden der Titandioxidschicht, der Kupferoxidschicht und der Calciumoxid- oder Calciumcarbonatschicht auf der Pufferschicht.

12. Herstellungsverfahren nach einem der Ansprüche 1 bis 11, wobei die Glühzeit der Glühbehandlung zwischen 30 Sekunden und 96 Stunden liegt; und/oder die Dicke des Calcium-Kupfer-Titanat-Films zwischen 1 Nanometer und 100 Mikrometer beträgt.

13. Herstellungsverfahren nach einem der Ansprüche 1 bis 12, wobei das Substrat mit einer 3D-Struktur versehen ist und die Titandioxidschicht, die Kupferoxidschicht und die Calciumoxid- oder Calciumcarbonatschicht die 3D-Struktur bedecken.

## Revendications

1. Procédé de préparation d'un film en titanate de calcium et de cuivre, comprenant :
la formation d'une structure de dépôt en couches sur un substrat, dans lequel la structure de dépôt en couches comprend au moins une couche de dioxyde de titane, au moins une couche d'oxyde de cuivre, et au moins une couche d'oxyde de calcium ou de carbonate de calcium ; et
la soumission de la structure de dépôt en couches à un traitement de recuit dans une atmosphère contenant de l'oxygène pour obtenir un film en titanate de calcium et de cuivre, dans lequel une température de recuit du traitement de recuit varie entre 500 °C et 1300 °C ;
dans lequel la formation de la structure de dépôt en couches sur le substrat comprend :
le dépôt de la couche de dioxyde de titane, le dépôt de la couche d'oxyde de cuivre, et le dépôt de la couche d'oxyde de calcium ou de carbonate de calcium sur le substrat respectivement à la manière d'un dépôt cyclique.

2. Procédé de préparation selon la revendication 1, dans lequel un rapport molaire entre un élément Ca, un élément Cu et un élément Ti dans la structure de dépôt en couches est égal ou proche de 1:3:4.

3. Procédé de préparation selon la revendication 1 ou 2, dans lequel la formation de la structure de dépôt en couches sur le substrat comprend :
le dépôt de la couche de dioxyde de titane, de la couche d'oxyde de cuivre, et de la couche d'oxyde de calcium ou de carbonate de calcium sur le substrat à l'aide d'un processus de dépôt de couches atomiques ou d'un processus de dépôt chimique en phase vapeur.

4. Procédé de préparation selon la revendication 1, dans lequel la formation de la structure de dépôt en couches sur le substrat comprend :
étape 1, le placement du substrat dans une chambre de réaction de dépôt de couches atomiques ;
étape 2, l'introduction en alternance d'un précurseur contenant du Ti et d'un précurseur contenant de l'oxygène dans la chambre de réaction de dépôt de couches atomiques, pour déposer la couche de dioxyde de titane sur le substrat ;
étape 3 : l'introduction en alternance d'un précurseur contenant du Cu et d'un précurseur contenant de l'oxygène dans la chambre de réaction de dépôt de couches atomiques, pour déposer la couche d'oxyde de cuivre sur la couche de dioxyde de titane ;
étape 4 : l'introduction en alternance d'un précurseur contenant du Ca et d'un précurseur contenant de l'oxygène dans la chambre de réaction de dépôt de couches atomiques, pour déposer la couche d'oxyde de calcium ou la couche de carbonate de calcium sur la couche d'oxyde de cuivre ; et
étape 5, l'exécution circulaire des étapes 2 à 4 N fois pour obtenir la structure de dépôt en couches.

5. Procédé de préparation selon la revendication 1, dans lequel la formation de la structure de dépôt en couches sur le substrat comprend :
étape 1, le placement du substrat dans une chambre de réaction de dépôt chimique en phase vapeur ;
étape 2, l'introduction simultanée d'un précurseur contenant du Ti et d'un précurseur contenant de l'oxygène dans la chambre de réaction de dépôt chimique en phase vapeur, pour déposer la couche de dioxyde de titane sur le substrat ;
étape 3, l'introduction simultanée d'un précurseur contenant du Cu et d'un précurseur contenant de l'oxygène dans la chambre de réaction de dépôt chimique en phase vapeur, pour déposer la couche d'oxyde de cuivre sur la couche de dioxyde de titane ;
étape 4 : l'introduction simultanée d'un précurseur contenant du Ca et d'un précurseur contenant de l'oxygène dans la chambre de réaction de dépôt chimique en phase vapeur, pour déposer la couche d'oxyde de calcium ou de carbonate de calcium sur la couche d'oxyde de cuivre ; et
étape 5, l'exécution circulaire des étapes 2 à 4 N fois pour obtenir la structure de dépôt en couches.

6. Procédé de préparation selon la revendication 4 ou 5, dans lequel le précurseur contenant de l'oxygène comprend au moins l'un parmi de l'oxygène, de l'ozone, de la vapeur d'eau, de l'oxyde nitreux, du plasma d'oxygène, du plasma d'ozone, du plasma d'eau et du plasma d'oxyde nitreux.

7. Procédé de préparation selon la revendication 1 ou 2, dans lequel la formation de la structure de dépôt en couches sur le substrat comprend :
le dépôt de la couche de dioxyde de titane, de la couche d'oxyde de cuivre, de la couche d'oxyde de calcium ou de carbonate de calcium, et d'une couche d'oxyde d'un élément dopé sur le substrat.

8. Procédé de préparation selon la revendication 7, dans lequel la couche d'oxyde de l'élément dopé est déposée à l'aide d'un processus de dépôt chimique en phase vapeur ou d'un processus de dépôt de couches atomiques.

9. Procédé de préparation selon la revendication 7 ou 8, dans lequel la couche d'oxyde de l'élément dopé est déposée sur une surface d'au moins l'un parmi
le substrat, la couche de dioxyde de titane, la couche d'oxyde de cuivre, et la couche d'oxyde de calcium ou de carbonate de calcium.

10. Procédé de préparation selon l'une quelconque des revendications 7 à 9, dans lequel l'élément dopé comprend au moins l'un parmi : Al, Nb, Sb, Zn, Pr, Sr, Fe, Ni, Y, B, Te, Co, Zr, Ga, La, Mg, Sm, Mn, Sc, Ba.

11. Procédé de préparation selon l'une quelconque des revendications1 à 10, comprenant en outre :
la préparation d'une couche tampon sur le substrat, dans lequel la couche tampon comprend au moins l'un parmi de l'oxyde de silicium, du nitrure de silicium, du titanate de zirconate de plomb et du titanate de baryum ;
la formation de la structure de dépôt en couches sur le substrat comprend :
le dépôt de la couche de dioxyde de titane, de la couche d'oxyde de cuivre et de la couche d'oxyde de calcium ou de carbonate de calcium sur la couche tampon.

12. Procédé de préparation selon l'une quelconque des revendications 1 à 11, dans lequel un temps de recuit du traitement de recuit varie entre 30 secondes et 96 heures ; et/ou une épaisseur du film en titanate de calcium et de cuivre est comprise entre 1 nanomètre et 100 micromètres.

13. Procédé de préparation selon l'une quelconque des revendications 1 à 12, dans lequel le substrat est pourvu d'une structure 3D, et la couche de dioxyde de titane, la couche d'oxyde de cuivre, et la couche d'oxyde de calcium ou de carbonate de calcium couvrent la structure 3D.
